(19) **Europäisches Patentamt European Patent Office Office européen des brevets**

(11) **EP 4 664 121 A1**

(12) **EUROPEAN PATENT APPLICATION**
published in accordance with Art. 153(4) EPC

(43) Date of publication:
**17.12.2025 Bulletin 2025/51**

(21) Application number: **23921269.9**

(22) Date of filing: **16.10.2023**

(51) International Patent Classification (IPC):
**G01R 29/08** (2006.01)

(52) Cooperative Patent Classification (CPC):
**G01R 29/08**

(86) International application number:
**PCT/JP2023/037364**

(87) International publication number:
**WO 2024/166445 (15.08.2024 Gazette 2024/33)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.02.2023 JP 2023017874**

(71) Applicant: **Hitachi, Ltd.
Tokyo 100-8280 (JP)**

(72) Inventor: **PAOLETTI Umberto
Tokyo 100-8280 (JP)**

(74) Representative: **MERH-IP Matias Erny Reichl
Hoffmann
Patentanwälte PartG mbB
Paul-Heyse-Straße 29
80336 München (DE)**

(54) **COMPUTER SYSTEM, NOISE SEPARATION METHOD, AND PROGRAM**

(57) To improve noise separation in one-channel measurement.

Provided is a computer system including one or more processors and one or more memory resources. The one or more processors are configured to execute: obtaining a signal including electromagnetic noise; defining a plurality of partial waves included in the signal; estimating, for at least some partial waves of the plurality of partial waves, an occurrence period at which each partial wave occurs in the signal; classifying at least some partial waves of the plurality of partial waves into a plurality of clusters with respect to a plurality of the occurrence periods; and filtering of removing, among the plurality of partial waves belonging to the same cluster, the partial wave, of the plurality of partial waves, that does not have similarity in feature to another partial wave of the plurality of partial waves, from the cluster.

[FIG. 2]

*FIG. 2*

**Description**

Technical Field

The present invention relates to a computer system, a noise separation method, and a program. The invention claims priority to Japanese Patent Application No. 2023-017874, filed on Feb. 8, 2023, the contents of which are incorporated herein by reference for designated countries where incorporation by reference of literature is allowed.

Background Art

There is a risk that various types of electromagnetic noise radiated from an electronic device, an electric train, an automobile, and the like may cause malfunction of an electronic device. Therefore, it is desirable to identify an electromagnetic noise source from which electromagnetic noise is emitted and take measures against the electromagnetic noise.

As a technique for identifying an electromagnetic noise source, there is a technique in which pieces of modulation frequency data of a plurality of electromagnetic noise sources are obtained in advance, and in which an electromagnetic noise source that emits electromagnetic noise is identified on the basis of each piece of the modulation frequency data and actually measured modulation frequency data (PTL 1). However, this technique is applicable only in a case where modulation frequency data of an electromagnetic noise source is known, and is inapplicable in a case where the location of an electromagnetic noise source is unknown and thereby modulation frequency data thereof is also unobtainable.

On the other hand, in a technique called blind source separation (BSS), a period or the like of an electromagnetic noise source can be identified without using preliminary information regarding the electromagnetic noise source.

Citation List

Patent Literature

PTL 1: EP 3 988 949 A

Summary of Invention

Technical Problem

In the BSS technique, it is preferable to obtain information leading to noise source identification with one-channel measurement, in order to enable easy identification of noise source. However, in the technique of PTL 1, there is room for improvement in noise separation in a case where frequency bands of a plurality of electromagnetic noise sources overlap in one-channel measurement.

The invention has been made in view of such circumstances, and an object of the invention is to improve noise separation in one-channel measurement.

Solution to Problem

In order to solve the above problem, a computer system according to an aspect of the invention is a computer system including: one or more processors; and one or more memory resources, in which the one or more processors are configured to execute: obtaining a signal including electromagnetic noise; defining a plurality of partial waves included in the signal; estimating, for at least some partial waves of the plurality of partial waves, an occurrence period at which each partial wave occurs in the signal; classifying at least some partial waves of the plurality of partial waves into a plurality of clusters with respect to a plurality of the occurrence periods; and filtering of removing, among the plurality of partial waves belonging to a same cluster of the plurality of clusters, the partial wave, of the plurality of partial waves, that does not have similarity in feature to another partial wave of the plurality of partial waves, from the same cluster.

Advantageous Effects of Invention

According to the invention, it is possible to improve noise separation in one-channel measurement.

Problems, configurations, and effects other than those described above will be made apparent by the following description of embodiments.

Brief Description of Drawings

[FIG. 1] FIG. 1 is a configuration diagram of an example of a computer system according to a first embodiment.
[FIG. 2] FIG. 2 is a flowchart illustrating an example of processing executed by the computer system in the first embodiment.
[FIG. 3] FIG. 3(a) is a schematic diagram of an example of signal data in the first embodiment, and FIG. 3(b) is a schematic diagram of an example of one partial wave in the first embodiment.
[FIG. 4] FIG. 4 is a schematic diagram illustrating an example of a digitized signal generated by a processor in step S3 of the first embodiment.
[FIG. 5] FIG. 5 is a schematic diagram illustrating an example of a sampling method in step S3 of the first embodiment.
[FIG. 6] FIG. 6 is a diagram in which an example of log-probability in the first embodiment is plotted for each candidate period.
[FIG. 7] FIG. 7 is a schematic diagram illustrating an example of a sampling method in step S4 of the first embodiment.
[FIG. 8] FIG. 8 is a diagram illustrating a display example in which a total count k in step S4 of the first embodiment is visualized.
[FIG. 9] FIG. 9 is a diagram illustrating a display example in which log-probability P(k) calculated from the total count k in FIG. 8 is visualized, in the first embodiment.
[FIG. 10] FIG. 10 is a diagram illustrating a display example in which negative log-probability P(k) is visualized for a "cluster 2" of an occurrence period different from that in FIG. 9, in the first embodiment.
[FIG. 11] FIG. 11 is a diagram illustrating a display example in which negative log-probability P(k) is visualized for a "cluster 3" of an occurrence period different from any of those in FIGS. 9 and 10, in the first embodiment.
[FIG. 12] FIG. 12 is a diagram illustrating an example of waveforms in which partial waves belonging to a "cluster 1" before filtering in step S5 of the first embodiment are superimposed.
[FIG. 13] FIG. 13 is a diagram illustrating an example of waveforms in which partial waves remaining in the "cluster 1" after the filtering in step S5 of the first embodiment are superimposed.
[FIG. 14] FIG. 14 is a diagram illustrating an example of frequency spectra of partial waves before the filtering in step S5 of the first embodiment.
[FIG. 15] FIG. 15 is a diagram illustrating an example of frequency spectra of partial waves after the filtering in step S5 of the first embodiment.
[FIG. 16] FIG. 16 is a flowchart illustrating an example of processing executed by a computer system in a second embodiment.
[FIG. 17] FIG. 17 is a flowchart illustrating an example of processing executed by a computer system in a third embodiment.
[FIG. 18] FIG. 18 is a flowchart illustrating an example of processing executed by a computer system in a fourth embodiment.
[FIG. 19] FIG. 19 is a configuration diagram of an example of a computer system according to a fifth embodiment.
[FIG. 20] FIG. 20 is a configuration diagram of an example of a computer system according to a sixth embodiment.

Description of Embodiments

An embodiment according to the invention will be hereinafter described with reference to the drawings. Note that throughout the drawings for describing the embodiments, the same members are denoted by the same reference signs in principle, and repeated description thereof will be omitted as appropriate. In addition, in the following embodiments, it goes without saying that constituent elements (including element steps and the like) thereof are not always indispensable unless otherwise specified explicitly or unless they are considered to be obviously indispensable in principle. Further, it goes without saying that when the phrases "formed of A", "comprising A", "having A", and "including A" are described, these are not intended to exclude other elements unless it is explicitly stated that A only is the element. Likewise, in the following embodiments, when a shape, positional relationship, or the like of a constituent element or the like is referred to, the shape or the like includes a shape or the like substantially approximate or similar thereto unless otherwise specified explicitly or unless it is considered to be obviously inapplicable in principle.

<First Embodiment>

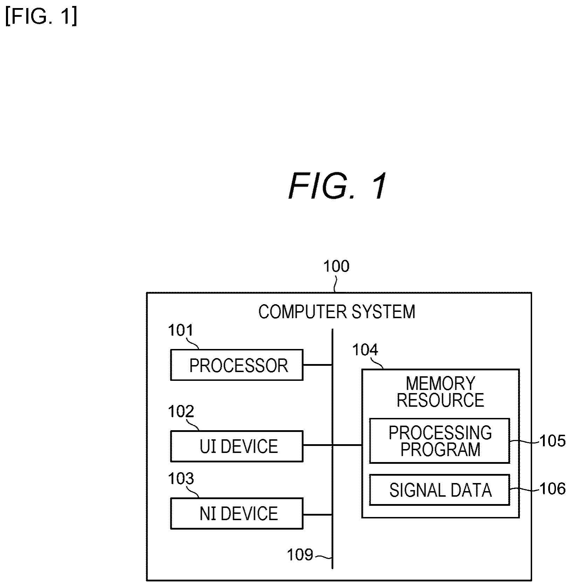

FIG. 1 is a configuration diagram of an example of a computer system according to the present embodiment.
A computer system 100 allows a processor therein to read a processing program stored in a memory resource, and thereby allows the processor to execute processing according to the processing program, in order to perform data generation, transmission, reception, and various other processing. Note that the computer system 100 is, for example, a computer, examples of which include a personal computer, a tablet terminal (computer), a smartphone, a server computer, a blade server, and a cloud server, and is a system including at least one or more of these computers. That is, the computer system 100 also includes a system including, for example, a cloud server and a computer for display (for example, a tablet terminal or a smartphone). In addition, a controller that controls or manages some device including a processor and a memory resource is also an example of the computer system 100.

Specifically, as illustrated in FIG. 1, the computer system 100 includes one or more processors 101, one or more user interface (UI) devices 102, one or more network interface (NI) devices 103, and one or more memory resources 104. Note that the computer system 100 may include other components. In addition, the processor 101, the UI device 102, the NI device 103, and the memory resource 104 are connected to each other via a bus 109.

The processor 101 is a calculation device that reads a processing program 105 stored in the memory resource 104 and that executes each processing of a noise separation method according to the present embodiment. Note that the processor 101 is, for example, a microprocessor, a central processing unit (CPU), a graphics processing unit (GPU), a field programmable gate array (FPGA), a quantum processor, or another semiconductor device able to perform calculation.

The memory resource 104 is a storage device that stores the processing program 105 and signal data 106, and is, for example, a non-volatile memory or/and a volatile memory. Examples of the volatile memory include a random access memory (RAM) and a read only memory (ROM). Examples of the non-volatile memory may include a rewritable storage medium such as a flash memory, a hard disk, or a solid state drive (SSD), or may include a universal serial bus (USB) memory, a memory card, a hard disk, and the like. In addition, a RAM such as a magnetoresistive RAM (MRAM), a phase change RAM (PRAM), or a resistive RAM (ReRAM may be regarded as a non-volatile memory. Note that the processor 101 may provide a service of distributing the processing program 105 stored in the memory resource 104 to another computer.

The UI device 102 is an input device that inputs an instruction of a user (or may be an operator) to the computer system 100, and an output device that outputs information or the like generated in the computer system 100. Examples of the input device include a pointing device such as a keyboard, a touch panel, a mouse, and a voice input device such as a microphone. In addition, examples of the output device include a display, a printer, and a speech synthesis device. Note that, unless otherwise mentioned below, input or output of information between the computer system 100 and the user is performed via the UI device 102. Note that the UI device 102 may be only the input device or only the output device.

The NI device 103 is a communication device that performs information communication with an external device. The NI device 103 performs the information communication with an external device via a predetermined communication network (not illustrated) such as the Internet or a local area network (LAN). Note that, unless otherwise mentioned below, the information communication between the computer system 100 (or the processor 101) and an external device is performed via the NI device 103.

The computer system 100 executes the processing program 105 to obtain the signal data 106 including electromagnetic noise, and stores the signal data 106 in the memory resource 104. The signal data 106 is time-series data of a signal including electromagnetic noise. For example, time-series data of voltage output from an oscilloscope (not illustrated) as a result of input, to the oscilloscope, an electromagnetic field intensity measured by a sensor (not illustrated) is the signal data 106. Examples of the sensor (not illustrated) that measures electromagnetic field intensity include an antenna, a current probe, and a voltage probe. As long as the time-series data of the signal including electromagnetic noise can be obtained, devices other than the oscilloscope (for example, an amplifier, a DA converter, a CPU for control, and a combination thereof) may be used. Further, the signal data 106 may be data obtained by executing various kinds of processing such as filtering or calibration on the time-series data.

Note that the phrase "one-channel measurement" herein at least means "using, or treating as a separation target, one piece of signal data 106 related to electromagnetic field intensity, output by one sensor". In a case where a plurality of pieces of signal data 106 is used by using a plurality of sensors at discrete positions or in different measurement directions, the direction of a noise source or a clue related to the direction is obtainable through triangulation or the like. However, in the case of "one piece of signal data 106, output by one sensor", a clue about such a direction is unobtainable. Therefore, the technique of the present example is useful. Note that a case of applying a multirole sensor capable of sensing electromagnetic field intensity and another physical quantity may also be included in the "one-channel measurement" described above. This is because when focusing on electromagnetic field intensity, the multirole sensor is also a "sensor that outputs one piece of signal data 106 related to electromagnetic field intensity". Note that the phrase "one-channel measurement" does not mean to completely exclude cross analysis with information related to another channel or noise conducted after noise separation.

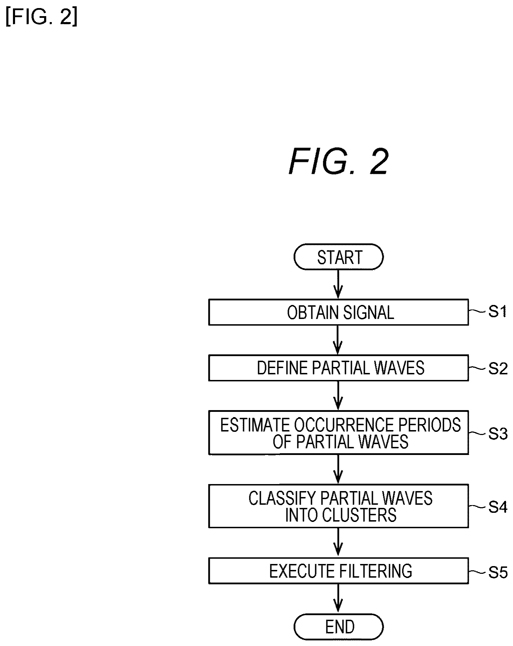

FIG. 2 is a flowchart illustrating an example of processing executed by the computer system 100 in the present embodiment.

First, the processor 101 obtains signal data 106 obtained with one-channel measurement made by a device such as the oscilloscope, and stores the signal data 106 in the memory resource 104 (step S1).

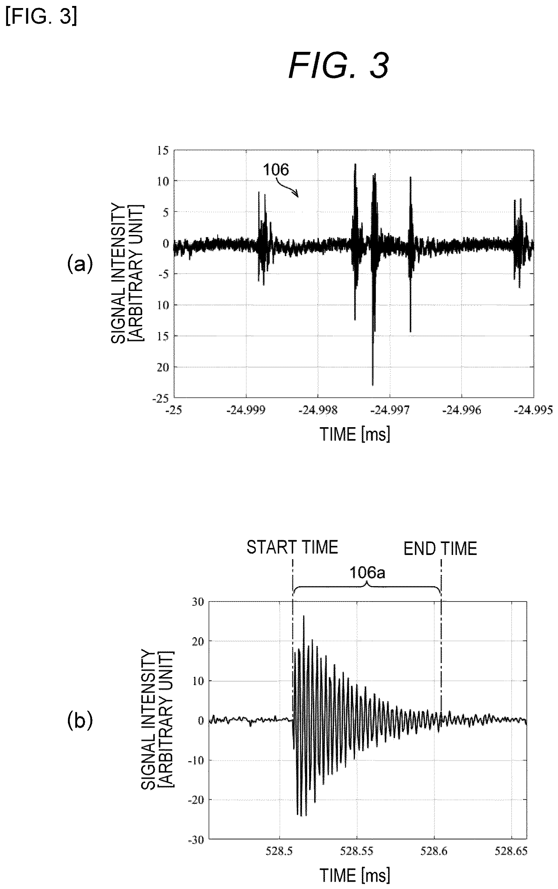

FIG. 3(a) is a schematic diagram of an example of the signal data 106. The signal data 106 is time-series data in which time and signal intensity are associated with each other.

FIG. 2 is referred to again. Next, the processor 101 defines a plurality of partial waves included in the signal data 106 (step S2).

FIG. 3(b) is a schematic diagram of an example of one partial wave 106a. The partial wave 106a is defined as a portion exceeding a threshold set by the user, in the signal data 106. The start time of the partial wave 106a is a time when the signal intensity becomes greater than or equal to a threshold, and the end time of the partial wave 106a is a time when the signal intensity becomes less than the threshold. In addition, the user may define the minimum time interval between two adjacent partial waves 106a in order to distinguish between the partial waves 106a close to each other.

The processor 101 stores the partial wave 106a and an ID for identifying the partial wave 106a in the memory resource 104 while associating the partial wave 106a with the ID. Further, the processor 101 stores the start time and the end time of the partial wave 106a in the memory resource 104 in association with the ID as a time frame during which the partial wave 106a is occurring.

FIG. 2 is referred to again. Next, the processor 101 estimates occurrence periods of the partial waves 106a on the basis of the start times or the end times of the partial waves 106a (step S3). In this step, it is not necessarily required that the occurrence periods of all the partial waves 106a be estimated. The processor 101 is simply required to estimate the occurrence periods of at least some of the plurality of partial waves 106a. The present embodiment is based on a type of BSS, and is premised on a situation in which an occurrence period of electromagnetic noise or the number of generation sources of electromagnetic noise is not known beforehand. In addition, the estimated occurrence period is presumed to be unique to the generation source of the electromagnetic noise.

Therefore, the processor 101 classifies the plurality of partial waves 106a into clusters with respect to the estimated occurrence periods (step S4). In this step, it is not necessarily required that all the partial waves 106a be classified into clusters. The processor 101 is simply required to classify at least some of the plurality of partial waves 106a into clusters.

Next, the processor 101 executes filtering of determining whether features of a plurality of partial waves 106a belonging to the same cluster are similar, and removing a partial wave 106a whose feature is determined to be not similar to that of another partial wave 106a from the cluster (step S5). As an example, the processor 101 uses a distance function that defines a distance between the partial waves 106a to remove a partial wave 106a whose distance to the other partial waves 106a exceeds a threshold, from the cluster.

With the completion of the processing described above, the basic processing executed by the computer system 100 in the present embodiment ends.

Next, details of steps S3 to S5 described above will be described.

<<Step S3>>

First, a method of estimating the occurrence period of the partial wave 106a in step S3 will be described.

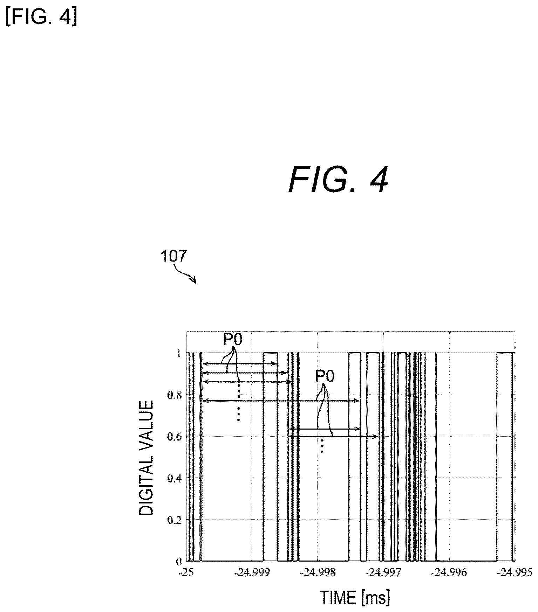

FIG. 4 is a schematic diagram illustrating an example of a digitized signal generated by the processor 101 in step S3.

As illustrated in FIG. 4, the processor 101 generates a digitized signal 107 obtained by digitizing the signal data 106 in accordance with occurrence and absence of the partial wave 106a. For example, the digitized signal 107 is time-series data in which a value of "1" is set in a time frame during which the partial wave 106a is occurring and a value of "0" is set in a time frame during which the partial wave 106a is absent. With this, the digitized signal 107 becomes a signal including a plurality of rectangular waves corresponding to the respective partial waves 106a. Therefore, hereinafter, the rectangular wave in the digitized signal 107 is also referred to as the partial wave 106a. In addition, the width of one rectangular wave is equal to duration during which the partial wave 106a corresponding to the rectangular wave continues.

Next, the processor 101 identifies a plurality of time intervals between the plurality of partial waves 106a in the digitized signal 107 as candidate periods P0 of the occurrence period of the electromagnetic noise. The candidate period P0 is identified for a combination of any two of the plurality of partial waves 106a. The candidate period P0 may be a time difference between the start times of the two partial waves 106a or a time difference between the end times of the two partial waves 106a.

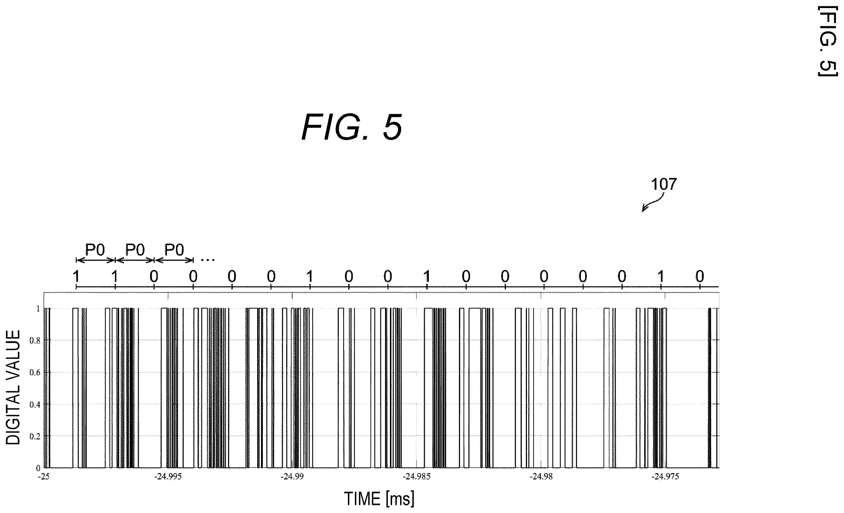

Then, the processor 101 executes sampling on the digitized signal 107. FIG. 5 is a schematic diagram illustrating an example of a sampling method in step S3.

As illustrated in FIG. 5, the processor 101 samples the partial waves 106a from the digitized signal 107 on the basis of the candidate period P0. The processor 101 executes such sampling for all the plurality of candidate periods P0. FIG. 5 illustrates a case in which the sampling is executed using one of the plurality of candidate periods P0.

The processor 101 sets "1" at the time when the partial wave 106a is sampled, and sets "0" at the time when the partial wave 106a is not sampled. Further, the processor 101 calculates a total count k of "1". The processor 101 calculates the total count k for all the candidate periods P0.

As the candidate period P0 is closer to a true occurrence period, the partial waves 106a occurring at this occurrence period are more likely to be sampled, and thus it can be expected that the total count k increases. However, it is not that simple in practice, and the total count k also depends on the duration and the occurrence period of the partial wave 106a. For example, the partial wave 106a having a long duration is likely to be sampled, and in a case where the occurrence period is shorter, more partial waves 106a are sampled, and the total count k increases.

Therefore, in the present embodiment, the total count k is evaluated in consideration of a probability that waves are sampled by chance from a random signal in which a plurality of waves is randomly distributed. As an example, in the present embodiment, a probability that the number of waves sampled from the random signal on the basis of the candidate period P0 is larger than the total count k is considered.

When a cumulative distribution function as to sampling of k or less waves in the random signal is represented by F(k), a negative log-probability P(k) is defined by Expression (1) below.

[Expression 1]

$$P(k) = -\log\left(1 - F(k)\right) \cdots (1)$$

In Expression (1), 1 - F(k) represents a complementary cumulative distribution function, and indicates a probability of sampling more than k waves in the random signal. The cumulative distribution function F(k) is not particularly limited, and may be a binomial distribution or a Poisson distribution. The negative log-probability P(k) is an indicator that increases as the probability (1 - F(k)) of sampling more than k waves in the random signal decreases. Therefore, a candidate period P0 with a large value of P(k) indicates a low probability that the total count becomes k by chance, and indicates a high probability that the candidate period P0 is equal to the true occurrence period of the electromagnetic noise.

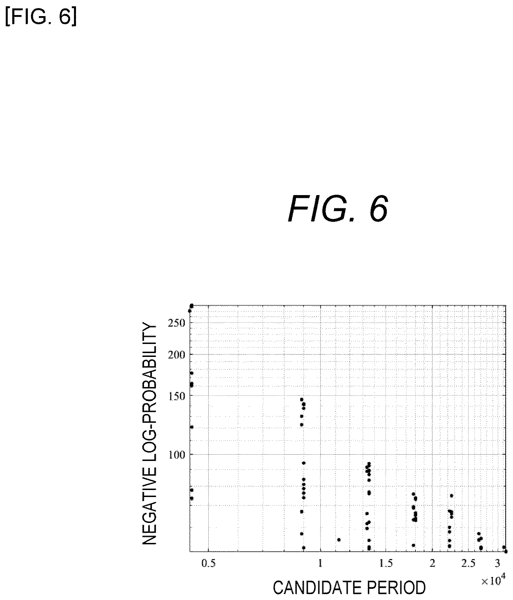

FIG. 6 is a diagram in which an example of log-probability calculated according to Expression (1) is plotted for each candidate period P0.

In the present embodiment, the processor 101 estimates a candidate period on the basis of which the negative log-probability P(k) is higher than or equal to a predetermined threshold, as a true occurrence period Pt. As a result, it is possible to extract a candidate period P0 close to a true occurrence period of electromagnetic noise by removing a candidate period P0 on the basis of which the total count has become k by chance.

At this time, there is a case in which a plurality of estimated true occurrence periods Pt exists. In this case, when a certain occurrence period Pt is an integral multiple of another occurrence period Pt, these occurrence periods Pt are equal to an occurrence period of the same noise source. Therefore, the processor 101 removes the occurrence period equal to the integral multiple of the other occurrence period. As a result, it is possible to remove an occurrence period related to the same noise source.

The occurrence period Pt corresponds to each noise source. Therefore, in a case where there is a plurality of noise sources, the number of occurrence periods Pt finally obtained in this step is also a plural number.

Note that the user may set the maximum value and the minimum value of the occurrence period Pt. In this case, the processor 101 deletes an occurrence period Pt smaller than the minimum value and an occurrence period Pt larger than the maximum value, and does not use them for subsequent processing.

<<Step S4>>

Next, a method of classification into clusters in step S4 will be described.

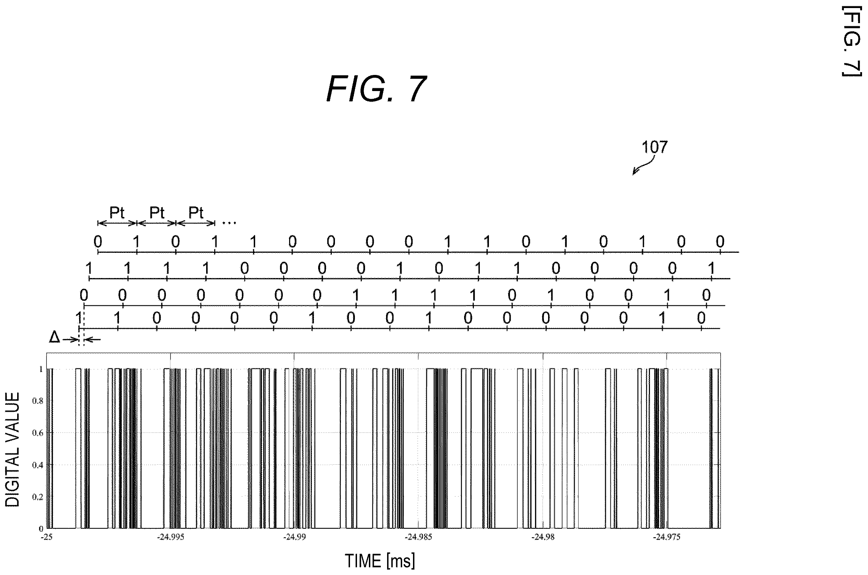

First, the processor 101 executes sampling on the digitized signal 107 with the occurrence period Pt estimated above. FIG. 7 is a schematic diagram illustrating an example of this sampling method.

As illustrated in FIG. 7, the processor 101 samples the partial waves 106a from the digitized signal 107 on the basis of the occurrence period Pt. In this example, the processor 101 sets "1" at the time when the partial wave 106a is sampled, and sets "0" at the time when the partial wave 106a is not sampled. Further, the processor 101 calculates the total count k of "1", and identifies the sampled partial waves 106a and their duration.

The time frames during which the respective partial waves 106a are occurring are stored in the memory resource 104. Therefore, the processor 101 can identify a time frame including the time when "1" is set among these time frames, as the duration of the partial wave 106a. Further, since the ID of the partial wave 106a is stored in the memory resource 104 in association with the time frame, the processor 101 can also identify the partial wave 106a at the time when "1" is set.

Further, the processor 101 executes the sampling described above for each of the plurality of occurrence periods Pt while changing a shift amount $\Delta$ by which the start time of the sampling is shifted. As a result, the processor 101 can obtain analysis data in which the total count k, the sampled partial wave 106a, the duration of the sampled partial wave 106a, the occurrence period Pt, and the shift amount $\Delta$ are associated with each other.

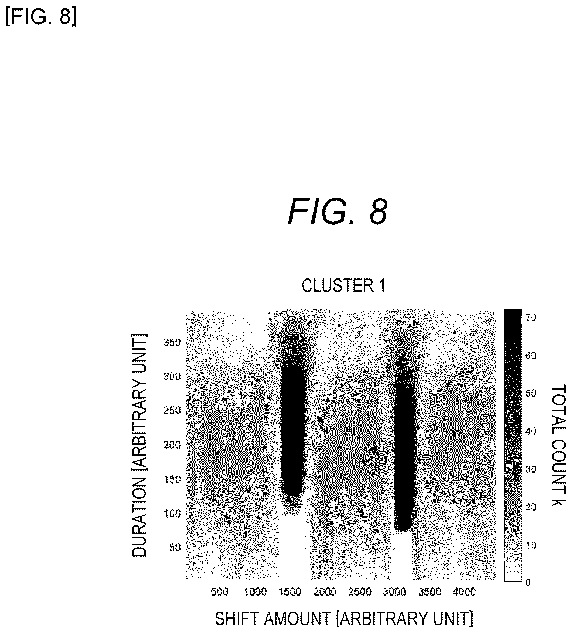

FIG. 8 is a diagram illustrating a display example in which the total count k associated with a certain occurrence period Pt in this analysis data is visualized.

Hereinafter, a cluster of the partial waves 106a associated with the occurrence period Pt of FIG. 8 is represented by a "cluster 1". In addition, in FIG. 8, the horizontal axis and the vertical axis represent the shift amount and the duration, respectively. The shade of the color indicates the total count k, and a darker color indicates an increase in the total count k.

In addition, hereinafter, the partial wave 106a associated with the occurrence period Pt, in the "cluster 1" is referred to as a partial wave 106a belonging to the "cluster 1".

A shading pattern in FIG. 8 is a pattern characterizing the partial waves 106a belonging to the "cluster 1". However, at this stage, light gray areas spread around black portions, and the shading pattern is not clear. This is because there is a shift amount on the basis of which the value of the total count k has increased by chance.

Therefore, the processor 101 makes the shading pattern clear by calculating the negative log-probability P(k) of Expression (1). The negative log-probability P(k) is an indicator that increases as the probability that the number of waves sampled on the basis of the occurrence period Pt from the random signal in which a plurality of waves is randomly distributed is larger than the total count k decreases.

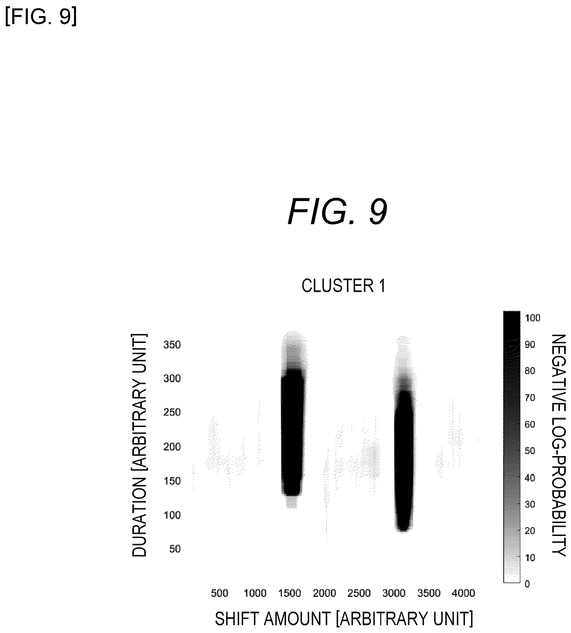

FIG. 9 is a diagram illustrating a display example in which the negative log-probability P(k) calculated from the total count k in FIG. 8 is visualized. Similarly to FIG. 8, the horizontal axis and the vertical axis in FIG. 9 represent the shift amount and the duration, respectively. Note that a binomial distribution is used as the cumulative distribution function F(k) of Expression (1).

As illustrated in FIG. 9, the peripheries of the black portions become close to white, and the shading pattern becomes clear as compared with FIG. 8.

Next, the processor 101 classifies partial waves 106a sampled with a shift amount on the basis of which the negative log-probability P(k) is higher than or equal to a predetermined threshold, when the digitized signal 107 is subjected to sampling on the basis of a certain occurrence period Pt as illustrated in FIG. 7, into a cluster of this occurrence period Pt. With this classification, it is possible to prevent classification of the partial waves 106a associated with a shift amount on the basis of which the value of the total count k has increased by chance, into this cluster, and accuracy of classification into a cluster is improved.

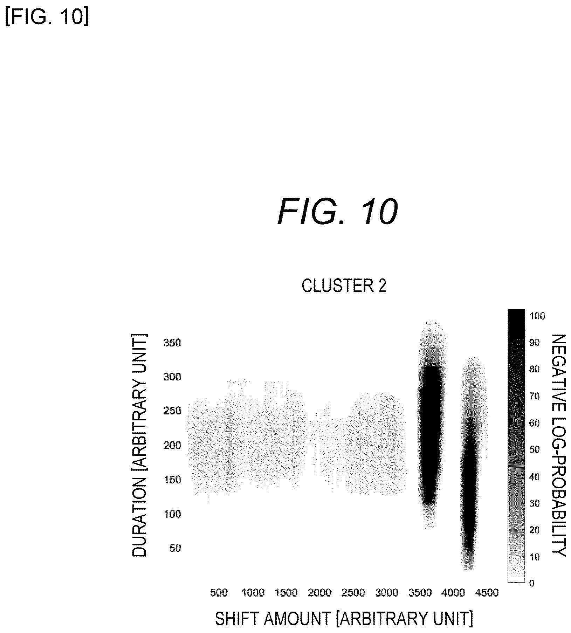

FIG. 10 is a diagram illustrating a display example in which negative log-probability P(k) is visualized for a "cluster 2" of an occurrence period Pt different from that in FIG. 9.

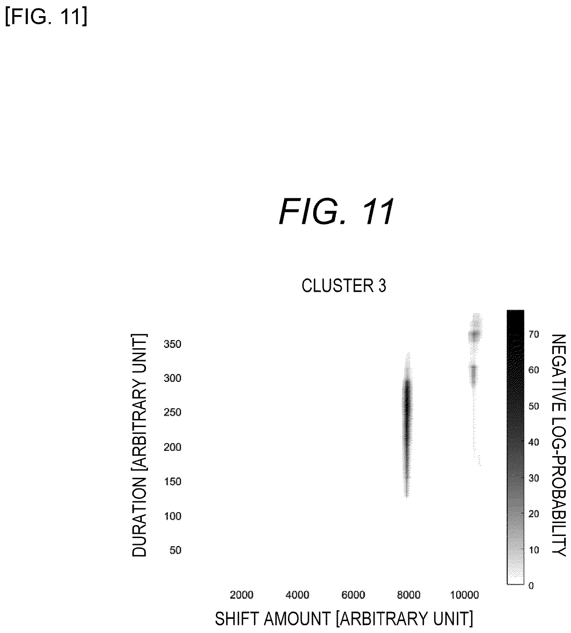

Further, FIG. 11 is a diagram illustrating a display example in which negative log-probability P(k) is visualized for a "cluster 3" of an occurrence period Pt different from any of those in FIGS. 9 and 10.

As illustrated in FIGS. 9 to 11, each of the shading patterns is a pattern characterizing a corresponding one of the clusters.

<<Step S5>>

Next, filtering in step S5 will be described.

In step S5, the processor 101 determines whether each of a plurality of partial waves 106a belonging to the same cluster is similar in feature to a partial wave 106a representing the cluster. Here, the processor 101 executes determination as to whether or not there is similarity in feature on the basis of a distance between partial waves 106a. For example, the processor 101 removes a partial wave 106a whose distance from a representative partial wave 106a of a certain cluster is greater than or equal to a predetermined threshold, from this cluster, and causes other partial waves 106a to remain in this cluster. The distance can be calculated from a cross-correlation value of the partial waves 106a in the signal data 106 before digitization. An example of the distance can be expressed as Expression (2) below.

[Expression 2]

$$\mathrm{dist}(x, y) = \sqrt{\sum (x - \bar{x})^2 + \sum (y - \bar{y})^2 - 2 \max \mathrm{xcorr}(x - \bar{x}, y - \bar{y}) + \bar{x}^2 + \bar{y}^2 - 2\bar{x}\bar{y}} \quad \cdots (2)$$

In Expression (2), x and y represent respective signal intensities of two partial waves 106a. In addition, each of the bars attached over x and y represents the mean value of the signal intensity over the duration of the partial wave 106a. Moreover, "mac xcorr" represents the maximum value of a cross-correlation value of the two arguments.

As a method for determining the partial wave 106a representing the cluster, there is a noise/possibilistic clustering (N/PC) algorithm disclosed in the following literatures [1] and [2].

[1] R.N. Dave and R. Krishnapuram, "Robust Clustering Methods: A Unified View," IEEE Trans. Fuzzy Systems, vol. 5, no. 2, pp. 270-293, 1997.

[2] R. Krishnapuram, J. M. Keller: "A Possibilistic Approach to Clustering," IEEE Transactions on Fuzzy Systems, vol. 1, no. 2, pp. 98-110, May 1993.

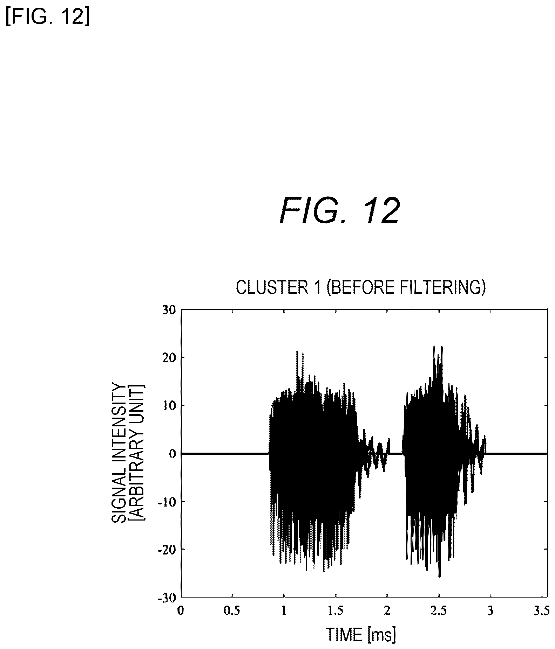

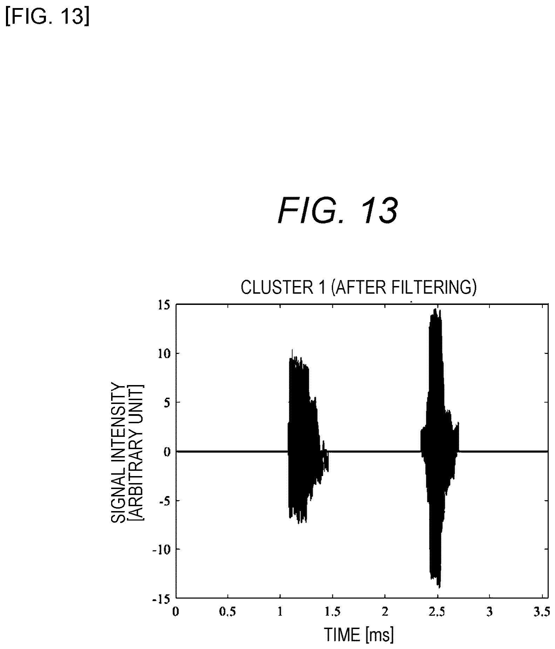

FIG. 12 is a diagram illustrating an example of waveforms in which partial waves 106a belonging to the "cluster 1" before the filtering in step S5 are superimposed. Further, FIG. 13 is a diagram illustrating an example of waveforms in which partial waves 106a remaining in the "cluster 1" after the filtering in step S5 are superimposed.

As is apparent from FIGS. 12 and 13, when filtering is executed on the basis of the distance, the number of partial waves 106a belonging to the same cluster decreases, and only partial waves 106a having similar waveforms can remain in the same cluster. The effect of filtering becomes more apparent when a frequency spectrum of the partial wave 106a belonging to each cluster is used.

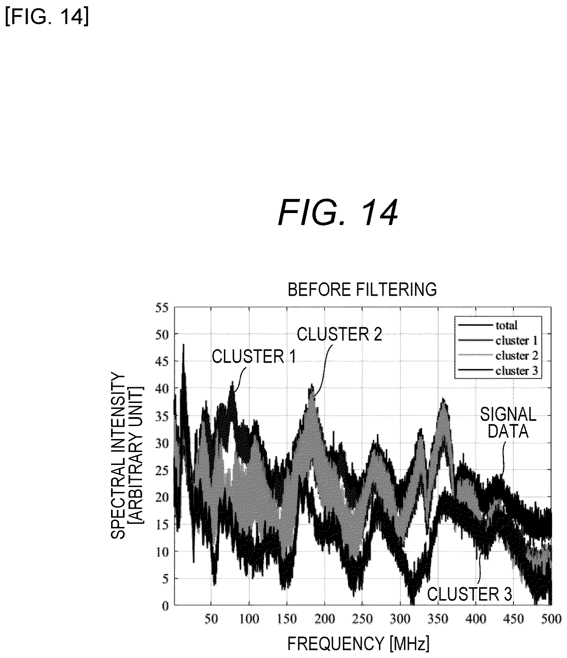

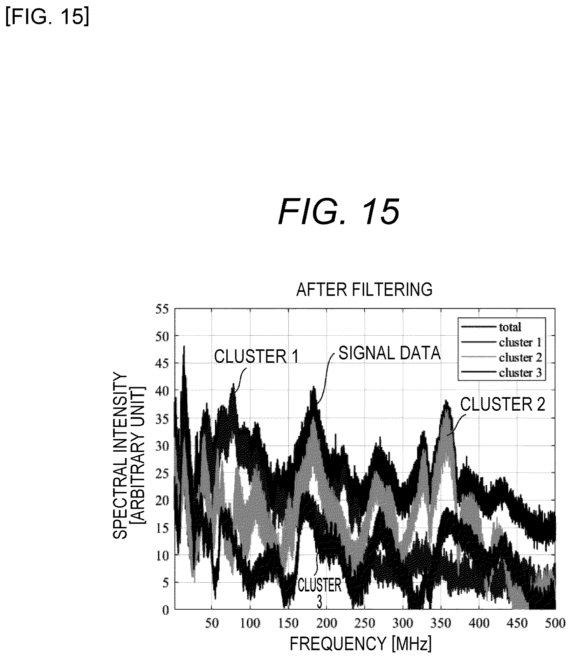

FIG. 14 is a diagram illustrating an example of frequency spectra of partial waves 106a before the filtering in step S5. Further, FIG. 15 is a diagram illustrating an example of frequency spectra of partial waves 106a after the filtering.

In each of FIGS. 14 and 15, "signal data" is a frequency spectrum of the original signal data 106. Moreover, "cluster 1", "cluster 2", and "cluster 3" are frequency spectra of the partial waves 106a belonging to these clusters.

As illustrated in FIG. 14, even before the filtering, it can be understood, to some extent, to which cluster the main component of electromagnetic noise at a certain frequency corresponds. For example, in the vicinity of a frequency of 70 MHz, the spectral intensity of the "cluster 1" is comparable to the spectral intensity of the "signal data", and thus it can be determined that the "cluster 1" is the main component of the electromagnetic noise.

However, at each of frequencies in the vicinities of 180 MHz, 330 MH, and 370 MHz, the respective spectral intensities of the "cluster 1" and the "cluster 2" are comparable to each other, and thus it is not possible to clearly determine to which cluster the main component of the electromagnetic noise corresponds.

On the other hand, as illustrated in FIG. 15, when the filtering is executed, it can be determined that the main component of the electromagnetic noise in each of the vicinities of 180 MHz, 330 MH, and 370 MHz is the "cluster 2".

According to the present embodiment described above, the occurrence periods of the partial waves 106a in the signal data 106 obtained with the one-channel measurement are estimated (step S3). Then, at least some of the plurality of partial waves 106a are classified into a plurality of clusters with respect to the occurrence periods (step S4), and a partial wave 106a whose feature is not similar to that of another partial wave 106a in the same cluster is removed from this cluster (step S5). As a result, it is possible to improve noise separation in the signal data 106 obtained with the one-channel measurement.

<Second Embodiment>

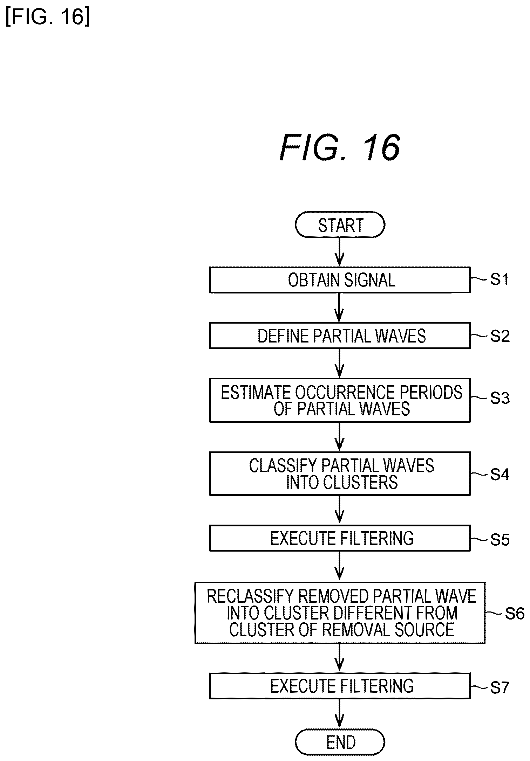

FIG. 16 is a flowchart illustrating an example of processing executed by a computer system 100 in the present embodiment. Note that in FIG. 16, the same steps as those in FIG. 2 are denoted by the same reference signs, and the description thereof will be omitted below.

In the present embodiment, the partial wave 106a removed through the filtering in step S5 is reclassified into a cluster as follows.

First, the processor 101 executes each processing of steps S1 to S5 according to the first embodiment.

Next, the processor 101 reclassifies the partial wave 106a removed through the filtering in step S5 into a cluster different from the cluster of the removal source (step S6). For example, the processor 101 classifies a certain partial wave 106a into a cluster whose frequency is closest to that of a cluster from which this partial wave 106a has been removed, among a plurality of clusters.

Next, the processor 101 executes filtering similar to that in step S5 again (step S7).

With the completion of the processing described above, the basic processing executed by the computer system 100 in the present embodiment ends.

According to the present embodiment described above, the number of partial waves 106a correctly classified into each cluster can be increased, and the number of partial waves 106a removed without being classified into a cluster can be reduced.

<Third Embodiment>

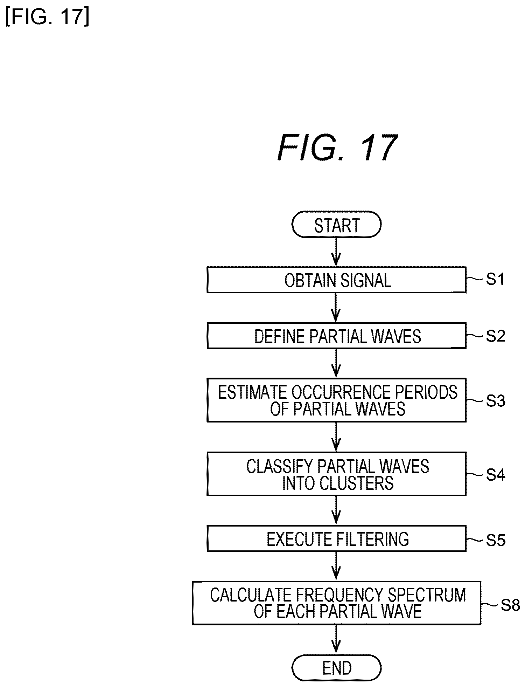

FIG. 17 is a flowchart illustrating an example of processing executed by a computer system 100 in the present embodiment. Note that in FIG. 17, the same steps as those in FIG. 2 are denoted by the same reference signs, and the description thereof will be omitted below.

In the present embodiment, the processor 101 calculates the frequency spectrum illustrated in FIG. 15 of the first embodiment.

First, the processor 101 executes each processing of steps S1 to S5 according to the first embodiment.

Next, the processor 101 calculates a frequency spectrum of each partial wave 106a belonging to each cluster (step S8). The processor 101 may instruct the UI device 102 to display the calculated frequency spectrum.

With the completion of the processing described above, the basic processing executed by the computer system 100 in the present embodiment ends.

To avoid interference of communication at a certain frequency, an electromagnetic noise level is often evaluated in a frequency domain. In the present embodiment, a spectrum in the frequency domain is calculated, and thus when the electromagnetic noise level is high at a specific frequency, the user can identify the main component of the electromagnetic noise at this frequency.

In addition, since each cluster corresponds to a single occurrence period, each cluster corresponds to a switching frequency of a device that repeats on and off on the basis of this occurrence period. Once the switching frequency is identified on the basis of the frequency spectrum, the device that turns on and off at that switching frequency can be identified from its specifications. As a result, the present embodiment can assist the user in identifying the device serving as an electromagnetic noise source.

<Fourth Embodiment>

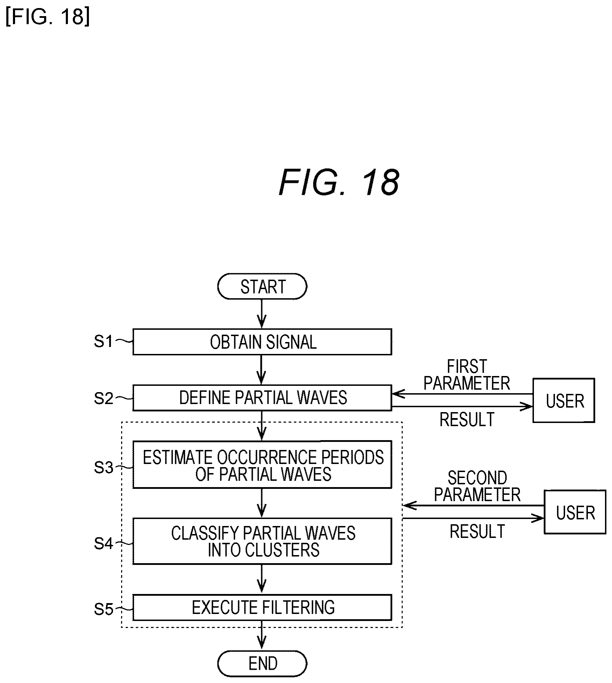

FIG. 18 is a flowchart illustrating an example of processing executed by a computer system 100 in the present embodiment. Note that in FIG. 18, the same steps as those in FIG. 2 are denoted by the same reference signs, and the description thereof will be omitted below.

As illustrated in FIG. 18, in the present embodiment, the processor 101 receives input of a parameter required for processing of each of steps S2 to S5, and the processor 101 instructs the UI device 102 to display a result of each processing.

For example, in step S2, the processor 101 receives input of a first parameter required for defining the partial wave 106a. As the first parameter, for example, there is a threshold for signal intensity for defining the partial wave 106a in the signal data 106. In addition, the minimum time interval between two adjacent partial waves 106a is also an example of the first parameter.

Then, the processor 101 instructs the UI device 102 to display the partial wave 106a defined on the basis of the first parameter, and the user confirms it.

On the other hand, in steps S3 to S5, the processor 101 receives input of a second parameter required in these steps.

For example, an example of the second parameters in step S3 is the maximum value and the minimum value of the occurrence period Pt. Then, after executing step S3, the processor 101 instructs the UI device 102 to display an occurrence period Pt between the maximum value and the minimum value.

As an example of the second parameter in step S4, there is a threshold for the negative log-probability $P(k)$ illustrated in FIG. 7. Then, after executing step S4, the processor 101 instructs the UI device 102 to display a cluster classified on the basis of the second parameter, and the user confirms it. As a display example of the cluster, for example, there is the shading pattern in each of FIGS. 9 to 11.

As an example of the second parameter in step S5, there is a threshold for a distance between a partial wave 106a included in a certain cluster and a partial wave 106a representing the cluster. Then, after executing step S5, the processor 101 instructs the UI device 102 to display the partial wave 106a included in each cluster.

According to the present embodiment described above, since the user can confirm a result of processing in accordance with the first parameter or the second parameter, a noise source can be identified while adjusting the first parameter or the second parameter.

<Fifth Embodiment>

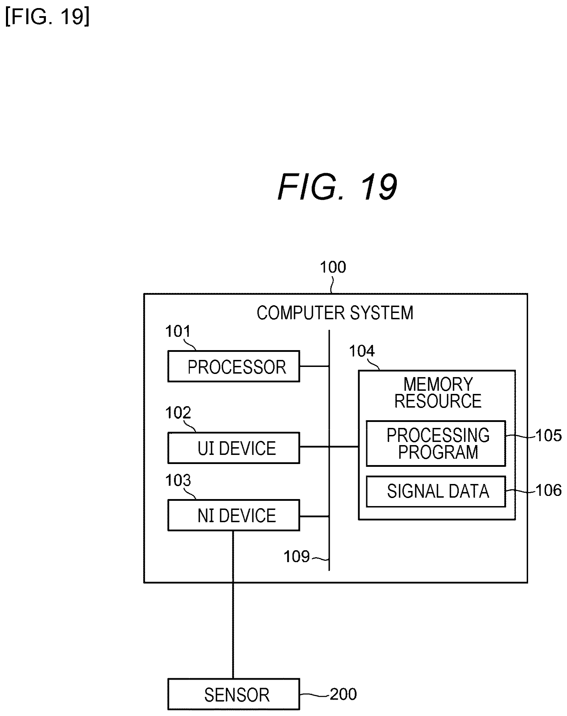

FIG. 19 is a configuration diagram of an example of a computer system according to the present embodiment. In FIG. 19, the same elements as those described in FIG. 1 are denoted by the same reference signs, and the description thereof will be omitted below.

As illustrated in FIG. 19, a computer system 100 according to the present embodiment includes at least one sensor 200 that obtains signal data 106. The sensor 200 is a physical device such as an antenna, a current probe, and a voltage probe installed in a space where electromagnetic noise is occurring, and is connected to the NI device 103 through a wired connection. With this configuration, the processor 101 can obtain the signal data 106 including the electromagnetic noise from the sensor 200.

<Sixth Embodiment>

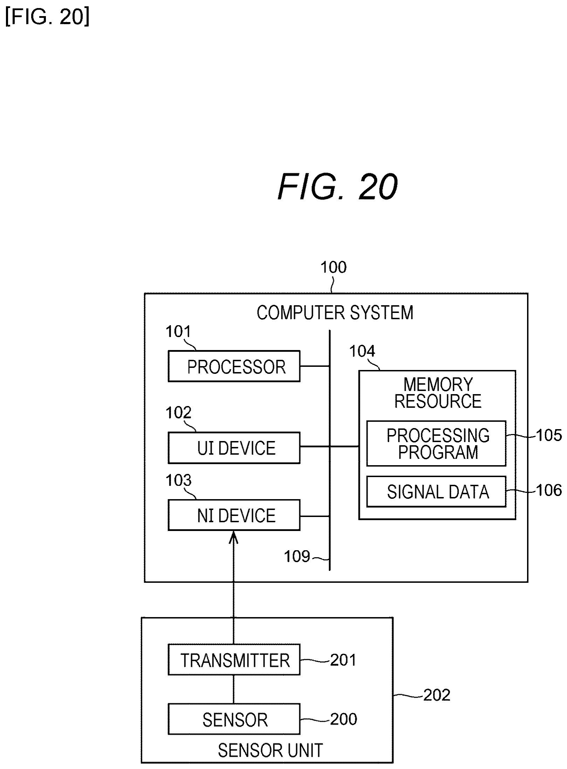

FIG. 20 is a configuration diagram of an example of a computer system according to the present embodiment. In FIG. 20, the same elements as those described in FIG. 1 are denoted by the same reference signs, and the description thereof will be omitted below.

As illustrated in FIG. 20, a computer system 100 according to the present embodiment includes at least one sensor unit 202 that obtains signal data 106. The sensor unit 202 includes the sensor 200 of the fifth embodiment and a transmitter 201. The transmitter 201 is a device that wirelessly transmits the signal data 106 obtained by the sensor 200.

According to this configuration, when the NI device 103 receives the signal data 106 from the transmitter 201, the processor 101 can obtain the signal data 106. In addition, since the transmitter 201 wirelessly transmits the signal data 106, the number of options of places in each of which the sensor unit 202 is installed can be increased.

The effects described herein are merely examples and are not limited, and other effects may be provided.

The invention is not limited to the embodiments described above, and includes various modifications. For example, the above embodiments have been described in detail for easy understanding of the invention. Therefore, the invention is not necessarily limited to those including all the constituent elements described therein. In addition, a part of the configuration of an embodiment can be replaced with the configuration of another embodiment, and the configuration of an embodiment can be added to the configuration of another embodiment. Further, a part of the configuration of each embodiment is allowed to accept addition of, removal of, and replacement with another configuration.

In addition, each of the configurations, functions, processing units, processing means, and the like described above may be partly or entirely implemented as hardware by, for example, designing them on an integrated circuit. Further, each of the configurations, functions, and the like described above may be implemented as software by causing a processor to interpret and execute a program for implementing the functions. Information for implementing functions, such as a program, a determination table, and a file can be stored in a storage device such as a memory, an HDD, or an SSD, or in a storage medium such as an integrated circuit (IC) card, a secure digital (SD) card, or a digital versatile disc (DVD). In addition, control lines and information lines are illustrated which are considered to be necessary for the description. Therefore, all the control lines and all the information lines for the product may not necessarily be illustrated. In practice, it may be considered that almost all the components are connected to one another.

This computer system 100 may be implemented by allowing a user (operator) to perform some or all of functions and processing to be implemented by the processing program 105.

Note that there is a case in which the computer system 100 does not include the UI device 102, and in which instead, a processor system (referred to as an external processor system) such as a smartphone or a tablet terminal outside the system is entrusted with a part of output processing to the user or input processing from the user. In such a case, the computer system 100 (or, the processor 101 or the processing program 105) may execute the followings, in order to execute the processing as described above or another part of the program.

[0110] * As an alternative to the output to the user using the UI device 102 described above, data required for the output to the user is transmitted to the external processor system via the NI device 103. Examples of this data are considered to include data to be output itself and data for causing another processor system to generate output data, but may include a program or web data in which processing of performing user output in the external processor system is described.

[0111] * As an alternative to the input or operation reception from the user using the UI device 102 described above, data indicating the user input or operation is received from the external processor system via the NI device 103. From another point of view, the meaning of the data output to the user may include causing (using) another entity other than the computer system 100 to execute the data output, in addition to allowing the computer system 100 itself to execute the data output. In addition, the meaning of the input or operation reception from the user may include the reception in an indirect manner by the computer system 100, in addition to output to the user or reception in a direct manner by the UI device 102 of the computer system 100.

Reference Signs List

| | |
|---|---|
| 100 | computer system |
| 101 | processor |
| 102 | UI device |
| 103 | NI device |
| 104 | memory resource |
| 105 | processing program |
| 106 | signal data |
| 106a | partial wave |
| 107 | digitized signal |
| 109 | bus |
| 200 | sensor |
| 201 | transmitter |
| 202 | sensor unit |

**Claims**

1.  A computer system, comprising:

one or more processors; and
one or more memory resources,
wherein the one or more processors are configured to execute:

obtaining a signal including electromagnetic noise;
defining a plurality of partial waves included in the signal;
estimating, for at least some partial waves of the plurality of partial waves, an occurrence period at which each partial wave occurs in the signal;
classifying at least some partial waves of the plurality of partial waves into a plurality of clusters with respect to a plurality of the occurrence periods; and
filtering of removing, among the plurality of partial waves belonging to a same cluster of the plurality of clusters, the partial wave, of the plurality of partial waves, that does not have similarity in feature to another partial wave of the plurality of partial waves, from the same cluster.

2. The computer system according to claim 1, wherein the estimating the occurrence period includes processing of:

generating a digitized signal obtained by digitizing the signal in accordance with occurrence and absence of each of the partial waves;
identifying a plurality of time intervals between the plurality of partial waves as candidate periods of the occurrence period; and
estimating, as the occurrence period, the candidate period, of the candidate periods, based on which an indicator that increases as a probability decreases is higher than or equal to a threshold, the probability being a probability that a number of a plurality of waves sampled based on the candidate period from a random signal in which the plurality of waves is randomly distributed is larger than a total count of the partial waves sampled based on the candidate period from the digitized signal.

3. The computer system according to claim 2, wherein the estimating the occurrence period includes processing of removing, when there is a plurality of the occurrence periods that has been estimated, the occurrence period, of the plurality of the occurrence periods, equal to an integral multiple of another occurrence period of the plurality of the occurrence periods.

4. The computer system according to claim 1, wherein the classifying into the plurality of clusters includes processing of:

generating a digitized signal obtained by digitizing the signal in accordance with occurrence and absence of each of the partial waves;
obtaining, for each of the plurality of the occurrence periods, a total count of the partial waves sampled based on the occurrence period from the digitized signal and the partial waves that have been sampled, while changing a shift amount by which a start time of sampling is shifted; and
classifying the partial wave sampled when being sampled with the shift amount based on which an indicator that increases as a probability, which is a probability that a number of a plurality of waves sampled based on the occurrence period from a random signal in which the plurality of waves is randomly distributed is larger than the total count, decreases is higher than or equal to a threshold, into the cluster, of the plurality of clusters, for the occurrence period.

5. The computer system according to claim 1, wherein determining whether there is the similarity in the feature is executed based on a distance between the partial waves.

6. The computer system according to claim 5, wherein the one or more processors are configured to execute:

reclassifying the partial wave that has been removed into the cluster, of the plurality of clusters, different from the cluster, of the plurality of clusters, that is a removal source; and
the filtering again after the reclassifying.

7. The computer system according to claim 1, wherein a frequency spectrum of each of the partial waves belonging to each of the plurality of clusters is calculated after the filtering.

8. The computer system according to claim 1, wherein the one or more processors are configured to execute:

receiving input of a parameter required for processing of any of the defining the plurality of partial waves, the estimating the occurrence period, the classifying into the plurality of clusters, and the filtering; and issuing an instruction to display a result of the processing.

9. The computer system according to claim 1, further comprising a sensor configured to obtain the signal.

10. The computer system according to claim 1, further comprising:

a sensor configured to obtain the signal; and
a transmitter configured to transmit the signal obtained by the sensor,
wherein the one or more processors are configured to obtain the signal transmitted by the transmitter.

11. A noise separation method executed by a computer system including one or more processors and one or more memory resources, the method comprising:

a step of obtaining a signal including electromagnetic noise;
a step of defining a plurality of partial waves included in the signal;
a step of estimating, for at least some partial waves of the plurality of partial waves, an occurrence period at which each partial wave occurs in the signal;
a step of classifying at least some partial waves of the plurality of partial waves into a plurality of clusters with respect to a plurality of the occurrence periods; and
a step of filtering of removing, among the plurality of partial waves belonging to a same cluster of the plurality of clusters, the partial wave, of the plurality of partial waves, that does not have similarity in feature to another partial wave of the plurality of partial waves, from the same cluster.

12. The noise separation method according to claim 11, wherein the step of estimating the occurrence period includes:

a step of generating a digitized signal obtained by digitizing the signal in accordance with occurrence and absence of each of the partial waves;
a step of identifying a plurality of time intervals between the plurality of partial waves as candidate periods of the occurrence period; and
a step of estimating, as the occurrence period, the candidate period, of the candidate periods, based on which an indicator that increases as a probability decreases is higher than or equal to a threshold, the probability being a probability that a number of a plurality of waves sampled based on the candidate period from a random signal in which the plurality of waves is randomly distributed is larger than a total count of the partial waves sampled based on the candidate period from the digitized signal.

13. The noise separation method according to claim 12, wherein the step of estimating the occurrence period includes a step of removing, when there is a plurality of the occurrence periods that has been estimated, the occurrence period, of the plurality of the occurrence periods, equal to an integral multiple of another occurrence period of the plurality of the occurrence periods.

14. The noise separation method according to claim 11, wherein the step of classifying the plurality of partial waves into the plurality of clusters with respect to the plurality of the occurrence periods includes:

a step of generating a digitized signal obtained by digitizing the signal in accordance with occurrence and absence of each of the partial waves;
a step of obtaining, for each of the plurality of the occurrence periods, a total count of the partial waves sampled based on the occurrence period from the digitized signal and the partial waves that have been sampled, while changing a shift amount by which a start time of sampling is shifted; and
a step of classifying the partial wave sampled when being sampled with the shift amount based on which an indicator that increases as a probability, which is a probability that a number of a plurality of waves sampled based on the occurrence period from a random signal in which the plurality of waves is randomly distributed is larger than the total count, decreases is higher than or equal to a threshold, into the cluster, of the plurality of clusters, for the occurrence period.

15. A program of causing a computer system to execute the noise separation method according to any one of claims 11 to 14.

[FIG. 1]

*FIG. 1*

100

COMPUTER SYSTEM

101

PROCESSOR

104

MEMORY RESOURCE

PROCESSING PROGRAM

105

102

UI DEVICE

SIGNAL DATA

106

103

NI DEVICE

109

[FIG. 2]

## FIG. 2

```
            ( START )
                │
                ▼
        ┌─────────────────┐
        │  OBTAIN SIGNAL  │─── S1
        └─────────────────┘
                │
                ▼
        ┌─────────────────────┐
        │ DEFINE PARTIAL WAVES │─── S2
        └─────────────────────┘
                │
                ▼
        ┌───────────────────────────┐
        │ ESTIMATE OCCURRENCE PERIODS │─── S3
        │     OF PARTIAL WAVES       │
        └───────────────────────────┘
                │
                ▼
        ┌───────────────────────┐
        │ CLASSIFY PARTIAL WAVES │─── S4
        │     INTO CLUSTERS      │
        └───────────────────────┘
                │
                ▼
        ┌──────────────────┐
        │ EXECUTE FILTERING │─── S5
        └──────────────────┘
                │
                ▼
            (  END  )
```

[FIG. 3]

# FIG. 3

(a)

(b)

[FIG. 4]

# FIG. 4

[FIG. 5]

FIG. 5

[FIG. 6]

FIG. 6

[FIG. 7]

*FIG. 7*

[FIG. 8]

# FIG. 8

CLUSTER 1

[FIG. 9]

FIG. 9

CLUSTER 1

[FIG. 10]

FIG. 10

CLUSTER 2

[FIG. 11]

FIG. 11

CLUSTER 3

[FIG. 12]

*FIG. 12*

CLUSTER 1 (BEFORE FILTERING)

[FIG. 13]

*FIG. 13*

CLUSTER 1 (AFTER FILTERING)

[FIG. 14]

# FIG. 14

BEFORE FILTERING

[FIG. 15]

*FIG. 15*

AFTER FILTERING

[FIG. 16]

## FIG. 16

```
        ( START )
            │
            ▼
┌──────────────────────────┐
│      OBTAIN SIGNAL       │─── S1
└──────────────────────────┘
            │
            ▼
┌──────────────────────────┐
│   DEFINE PARTIAL WAVES   │─── S2
└──────────────────────────┘
            │
            ▼
┌──────────────────────────┐
│ ESTIMATE OCCURRENCE PERIODS │─── S3
│    OF PARTIAL WAVES      │
└──────────────────────────┘
            │
            ▼
┌──────────────────────────┐
│  CLASSIFY PARTIAL WAVES  │─── S4
│      INTO CLUSTERS       │
└──────────────────────────┘
            │
            ▼
┌──────────────────────────┐
│     EXECUTE FILTERING    │─── S5
└──────────────────────────┘
            │
            ▼
┌──────────────────────────────┐
│ RECLASSIFY REMOVED PARTIAL WAVE │─── S6
│  INTO CLUSTER DIFFERENT FROM   │
│    CLUSTER OF REMOVAL SOURCE   │
└──────────────────────────────┘
            │
            ▼
┌──────────────────────────┐
│     EXECUTE FILTERING    │─── S7
└──────────────────────────┘
            │
            ▼
        (  END  )
```

[FIG. 17]

# FIG. 17

```
        ┌──────────┐
        │  START   │
        └────┬─────┘
             ↓
  ┌────────────────────────┐
  │     OBTAIN SIGNAL      │─── S1
  └───────────┬────────────┘
              ↓
  ┌────────────────────────┐
  │   DEFINE PARTIAL WAVES │─── S2
  └───────────┬────────────┘
              ↓
  ┌────────────────────────┐
  │ ESTIMATE OCCURRENCE    │
  │ PERIODS                │─── S3
  │ OF PARTIAL WAVES       │
  └───────────┬────────────┘
              ↓
  ┌────────────────────────┐
  │  CLASSIFY PARTIAL WAVES│
  │  INTO CLUSTERS         │─── S4
  └───────────┬────────────┘
              ↓
  ┌────────────────────────┐
  │   EXECUTE FILTERING    │─── S5
  └───────────┬────────────┘
              ↓
  ┌────────────────────────┐
  │ CALCULATE FREQUENCY    │
  │ SPECTRUM               │─── S8
  │ OF EACH PARTIAL WAVE   │
  └───────────┬────────────┘
              ↓
        ┌──────────┐
        │   END    │
        └──────────┘
```

[FIG. 18]

# FIG. 18

[FIG. 19]

# FIG. 19

[FIG. 20]

*FIG. 20*

100

COMPUTER SYSTEM

101
PROCESSOR

104
MEMORY RESOURCE

105
PROCESSING PROGRAM

106
SIGNAL DATA

102
UI DEVICE

103
NI DEVICE

109

202
SENSOR UNIT

201
TRANSMITTER

200
SENSOR

## INTERNATIONAL SEARCH REPORT

| | International application No. |
|---|---|
| | **PCT/JP2023/037364** |

### A. CLASSIFICATION OF SUBJECT MATTER

*G01R 29/08*(2006.01)i
FI: G01R29/08 D

According to International Patent Classification (IPC) or to both national classification and IPC

### B. FIELDS SEARCHED

Minimum documentation searched (classification system followed by classification symbols)

G01R29/08; G01R23/10; G01R23/15

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2006-71428 A (SONY CORPORATION) 16 March 2006 (2006-03-16)<br>entire text, all drawings | 1-15 |
| A | JP 2006-84413 A (SONY CORPORATION) 30 March 2006 (2006-03-30)<br>entire text, all drawings | 1-15 |
| A | JP 2016-225759 A (FUJITSU TEN LTD.) 28 December 2016 (2016-12-28)<br>entire text, all drawings | 1-15 |
| A | CN 115438704 A (MOER XIANCHENG INTELLIGENT TECHNOLOGY (BEIJING) CO.,<br>LTD.) 06 December 2022 (2022-12-06)<br>entire text, all drawings | 1-15 |
| A | JP 7-35792 A (HITACHI, LTD.) 07 February 1995 (1995-02-07)<br>entire text, all drawings | 1-15 |
| A | JP 2006-10518 A (FUNAI ELECTRIC CO., LTD.) 12 January 2006 (2006-01-12)<br>entire text, all drawings | 1-15 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 November 2023** | **28 November 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2023/037364**

| Patent document cited in search report | | | Publication date (day/month/year) | Patent family member(s) | | | Publication date (day/month/year) |
|---|---|---|---|---|---|---|---|
| JP | 2006-71428 | A | 16 March 2006 | (Family: none) | | | |
| JP | 2006-84413 | A | 30 March 2006 | (Family: none) | | | |
| JP | 2016-225759 | A | 28 December 2016 | US entire text, all drawings DE | 2016/0352371 102016109202 | A1 A1 | |
| CN | 115438704 | A | 06 December 2022 | CN entire text, all drawings | 116304630 | A | |
| JP | 7-35792 | A | 07 February 1995 | (Family: none) | | | |
| JP | 2006-10518 | A | 12 January 2006 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023017874 A

- EP 3988949 A

**Non-patent literature cited in the description**

- Robust Clustering Methods: A Unified View. **R.N. DAVE** ; **R. KRISHNAPURAM**. Trans. Fuzzy Systems. IEEE, 1997, vol. 5, 270-293

- A Possibilistic Approach to Clustering. **R. KRISH-NAPURAM** ; **J. M. KELLER**. Transactions on Fuzzy Systems. IEEE, May 1993, vol. 1, 98-110